# FASCICULE DE BREVET EUROPEEN

(11) **EP 3 871 254 B1**
(45) Date de publication et mention de la délivrance du brevet: **08.10.2025**
(21) Numéro de dépôt: 19786322.8
(22) Date de dépôt: 08.10.2019
(51) Int. Cl.: H01L 25/075, H01L 21/683, H01L 25/16, H10H 20/857

(54) **DISPOSITIF ELECTRONIQUE**
ELEKTRONISCHE VORRICHTUNG
ELECTRONIC DEVICE

(30) Priorité: 24.10.2018 FR 1871290
(43) Date de publication de la demande: 01.09.2021
(73) Titulaire: Aledia, 38800 Champagnier (FR)
(72) Inventeur: ROBIN, Ivan-Christophe, 38000 GRENOBLE (FR); BOUHAMRI, Zine, 69100 VILLEURBANNE (FR); GILET, Philippe, 38470 TECHE (FR)
(74) Mandataire: Cabinet Beaumont
(86) Numéro de dépôt international: PCT/EP2019/077264
(87) Numéro de publication internationale: WO 2020/083638

(56) Documents cités:
- WO-A1-2016/007175
- US-A1- 2015 249 069
- US-A1- 2016 322 283
- US-A1- 2017 077 007

## Description

La présente demande de brevet revendique la priorité de la demande de brevet français FR18/71290 qui sera considérée comme faisant partie intégrante de la présente description.

### Domaine technique

La présente description concerne des dispositifs électroniques comprenant une pluralité de puces électroniques et leurs procédés de fabrication.

US 2015/249069 décrit un tel procédé.

### Technique antérieure

Il existe des dispositifs électroniques comprenant une pluralité de puces électroniques similaires. Ces puces peuvent être espacées les unes des autres et agencées selon une matrice. Par exemple, les écrans d'affichage comprennent une pluralité de pixels d'affichage formés similairement. La fabrication de tels dispositifs peut comprendre une étape de placement selon une technique dite "Pick and Place" au cours de laquelle chaque pixel d'affichage individualisé est déposé à l'emplacement désiré séparément des autres. Cette technique peut être longue et coûteuse lorsque le nombre de pixels d'affichage est élevé.

### Résumé de l'invention

Un objet d'un mode de réalisation est de pallier tout ou partie des inconvénients des dispositifs électroniques et leurs procédés de fabrication décrits précédemment.

Ainsi, la présente invention est définie dans la revendication 1.
c) retirer et/ou graver la plaque ; et
d) étirer le premier support de manière à écarter les puces les unes des autres.

Selon un mode de réalisation, le procédé comprend, avant l'étape b), une étape de formation de premiers éléments conducteurs sur le premier support.

Selon un mode de réalisation, les premiers éléments conducteurs sont étirables et/ou déformables.

Selon un mode de réalisation, la formation des premiers éléments conducteurs comprend les étapes suivantes :
former une couche conductrice sur un substrat ;
graver la couche conductrice de manière à former les premiers éléments conducteurs, les premiers éléments conducteurs comprenant des plots et des bandes en forme de zig-zag, chaque bande étant en contact avec au moins un plot ; et
reporter les plots et les bandes sur le premier support de manière que les bandes ne soient pas en contact avec le premier support.

Selon un mode de réalisation, l'épaisseur des bandes est inférieure à l'épaisseur des plots.

Selon un mode de réalisation, le procédé comprend, avant l'étape b), la formation de cavités dans le premier support, chaque puce étant située dans l'une des cavités après l'étape b).

Selon un mode de réalisation, le procédé comprend la formation de deuxièmes éléments conducteurs sur le côté des puces opposé au premier support et/ou au-dessus des puces.

Selon un mode de réalisation, la formation des deuxièmes éléments conducteurs est effectuée après l'étape d).

Selon un mode de réalisation, chaque puce électronique comprend un circuit optoélectronique et un circuit électronique adapté à commander le circuit optoélectronique.

Selon un mode de réalisation, chaque puce électronique comprend uniquement deux bornes externes de connexion électronique.

Selon un mode de réalisation, le procédé comprend les étapes suivantes postérieures à l'étape d) :
e) former, du côté d'une face émettrice de lumière, des éléments conducteurs, sensiblement transparents au rayonnement émis par les puces de manière à interconnecter des lignes de puces ;
f) reporter les puces sur un troisième support sensiblement transparent au rayonnement émis par les puces ;
g) retirer le premier support ;
h) former des couches conductrices de manière à interconnecter des colonnes de puces ;

Selon un mode de réalisation, le report sur le deuxième support est effectué après l'étape h).

Selon un mode de réalisation, le premier support comprend des premiers éléments conducteurs formant des lignes, chaque puce étant connectée, à l'étape b), à l'un des éléments conducteurs.

Selon un mode de réalisation, des deuxièmes éléments conducteurs formant des colonnes sont formés sur la face des puces opposée au premier support.

Il est possible de réaliser un dispositif électronique obtenu par un procédé tel que décrit précédemment, dans lequel les puces électroniques sont situées sur les éléments conducteurs, les éléments conducteurs reposant sur le premier support en un matériau étirable dans un état étiré.

Dans une forme de réalisation, chaque puce électronique est un pixel d'affichage.

Dans une forme de réalisation, le dispositif correspond à un écran d'affichage.

Dans une forme de réalisation, chaque puce électronique comprend un plot conducteur connecté électriquement à l'élément conducteur reposant sur le premier support.

Dans une forme de réalisation, les éléments conducteurs sont étirables et/déformables.

Dans une forme de réalisation, chaque puce électronique est située au moins partiellement dans une cavité du support.

### Brève description des dessins

Ces caractéristiques et avantages, ainsi que d'autres, seront exposés en détail dans la description suivante de modes de réalisation particuliers, en relation avec les figures jointes parmi lesquelles :
la figure 1 est une vue en coupe, partielle et schématique, d'un mode de réalisation d'un dispositif électronique ;
la figure 2 illustre des étapes d'un mode de réalisation d'un procédé de fabrication du dispositif électronique de la figure 1 ;
la figure 3 illustre d'autres étapes d'un mode de réalisation d'un procédé de fabrication du dispositif électronique de la figure 1 ;
la figure 4 illustre d'autres étapes d'un mode de réalisation d'un procédé de fabrication du dispositif électronique de la figure 1 ;
la figure 5 est une vue en coupe, partielle et schématique, d'un autre mode de réalisation d'un dispositif électronique ;
la figure 6 représente une vue de dessus schématique et partielle du mode de réalisation de la figure 5 ;
la figure 7 illustre des étapes d'un mode de réalisation d'un procédé de fabrication du dispositif électronique de la figure 5 ;
la figure 8 représente des vues en coupe, partielles et schématiques, illustrant des étapes d'un mode de réalisation d'un procédé de fabrication d'un autre mode de réalisation d'un dispositif électronique ;
la figure 9 est une vue en coupe, partielle et schématique, d'un autre mode de réalisation d'un dispositif électronique ;
la figure 10 illustre des étapes d'un mode de réalisation d'un procédé de fabrication d'éléments conducteurs ;
la figure 11 illustre des étapes d'un mode de réalisation d'un procédé de fabrication d'éléments conducteurs ;
la figure 12 est une vue en coupe partielle et schématique d'un autre mode de réalisation d'un dispositif électronique ; et
la figure 13 illustre des étapes d'un mode de réalisation d'un procédé de fabrication du dispositif électronique de la figure 12.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

On considère ici que les termes "isolant" et "conducteur" signifient respectivement "isolant électriquement" et "conducteur électriquement".

Un pixel d'affichage d'une image correspond à l'élément unitaire de l'image affichée par un dispositif optoélectronique. Lorsque le dispositif optoélectronique est un écran d'affichage d'images couleur, il comprend, en général, pour l'affichage de chaque pixel d'affichage de l'image, au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel d'affichage de l'image affichée. Dans ce cas, on appelle pixel d'affichage du dispositif optoélectronique l'ensemble formé par les trois sous-pixels d'affichage utilisés pour l'affichage d'un pixel d'affichage d'une image.

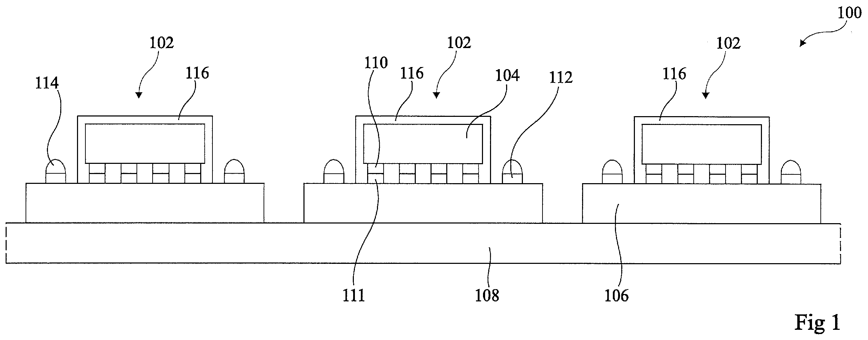

La figure 1 est une vue en coupe, partielle et schématique, représentant un mode de réalisation d'un dispositif électronique 100. Le dispositif électronique 100 comprend une pluralité de puces électroniques 102 disposées sur un support 108 en un matériau étirable, trois puces étant représentées en figure 1. Le dispositif 100 est par exemple un écran d'affichage dans lequel les puces sont des pixels d'affichage 102.

Chaque pixel d'affichage 102 comprend un circuit optoélectronique 104 et un circuit électronique 106. Chaque circuit optoélectronique 104 comprend par exemple plusieurs sous-pixels d'affichage, par exemple trois, les sous-pixels d'affichage émettant par exemple des rayonnements dans des plages de longueurs d'onde différentes. Chaque circuit électronique 106 correspond par exemple à une puce de circuit intégré et comprend par exemple un circuit de commande des sous-pixels d'affichage du circuit optoélectronique 104. Les circuits 104 et 106 sont connectés par des plots conducteurs 110 du circuit optoélectronique 104 et des plots conducteurs 111 du circuit électronique 106. Les plots conducteurs 110 et 111 sont par exemple en relief, comme en figure 1, ou peuvent affleurer la face des circuits 104 et 106 de telle manière que les circuits 104 et 106 soient collés par collage direct hétérogène. Le circuit électronique 106 comprend de plus des plots conducteurs 112 supplémentaires non directement connectés au circuit optoélectronique 104. Par exemple chaque pixel d'affichage 102 comprend quatre plots supplémentaires 112. Des éléments conducteurs 114, par exemple des bandes conductrices, s'étendent sur le support 108 et sur les circuits électroniques 106, en particulier au contact des plots 112. Les bandes conductrices 114 peuvent connecter ensemble plusieurs pixels d'affichage. Chaque pixel d'affichage 102 peut recevoir des signaux électroniques, notamment de commande et/ou d'alimentation, par l'intermédiaire des éléments conducteurs 114 et des plots 112.

Pour chaque pixel d'affichage 102, un revêtement isolant 116 recouvre le circuit optoélectronique 104 et les plots conducteurs 110 et 111.

Le support 108 est en un matériau étirable, par exemple en un matériau compris dans le groupe comprenant les matériaux évoqués dans les brevets US 4222913 et US 4379197, des résines polyéthylène sans groupe polymérisés d'acétate de vinyle, des polymères acrylate comme les composants suivants : 2-ethylhexyl acrylate, n-butyl acrylate, methyl acrylate et t-butyl méthacrylate. On définit un matériau étirable comme étant un matériau dont le module de déformation longitudinale, c'est-à-dire le rapport entre la contrainte et l'allongement relatif, est compris entre 102 Pa et 106 Pa. De préférence, le support 108 est adapté à se déformer avec un allongement à la limite de rupture supérieur à 150 % de préférence supérieur à 300 %. Le support 108 est par exemple en un matériau étirable isolant.

Le support étirable 108 du dispositif électronique 100 est de préférence dans un état étiré, c'est-à-dire que des forces de traction sont exercées, ou ont été exercées, sur le support de telle manière que la surface du support étiré en vue de dessus corresponde de 150 % à 10000 % de la surface du même support 108 sur lequel ne sont pas exercées de forces de traction. L'état étiré du support 108 peut être maintenu par des moyens mécaniques. A titre de variante, le support 108 peut avoir été étiré au-delà de la limite élastique. Le support 108 peut alors rester déformé sans être maintenu par des moyens externes.

Le dispositif électronique 100 comprend par exemple de 3 à 106 puces 102. Le support 108 a, à l'état non étiré, par exemple une épaisseur comprise entre environ 1 µm et 1000 µm. A l'état étiré, le support 108 a par exemple une épaisseur comprise entre environ 10 nm et 200 µm. L'écart entre deux puces 102 adjacentes est par exemple compris entre 0,5 µm et 100 cm à l'état non étiré et entre 3 µm et 10 cm à l'état étiré.

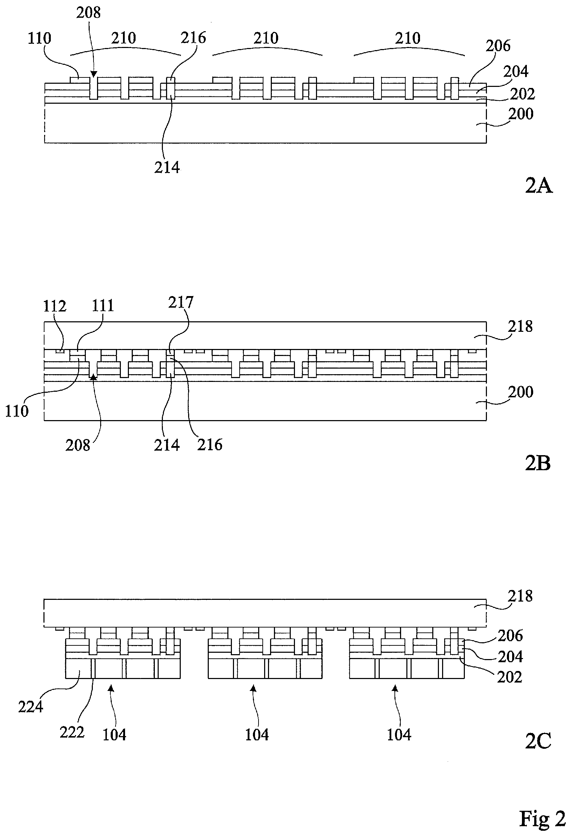

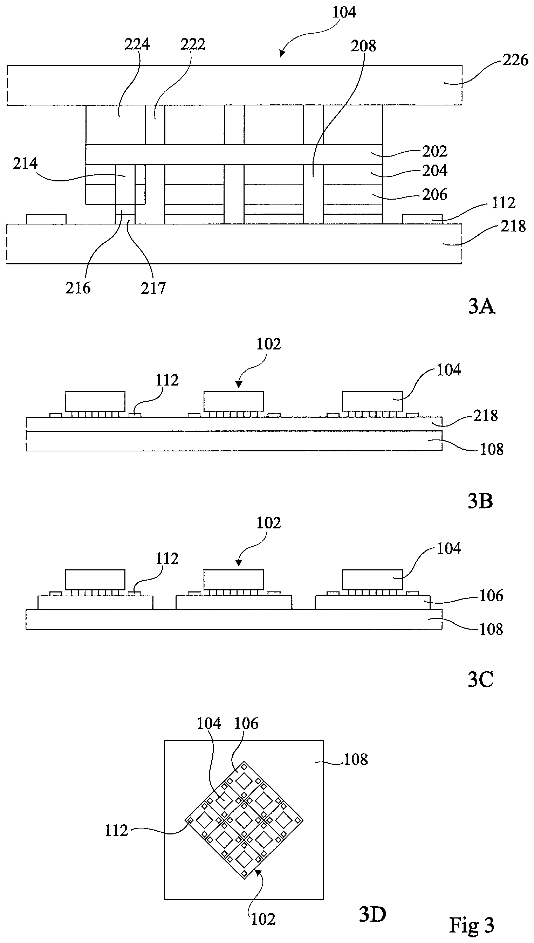

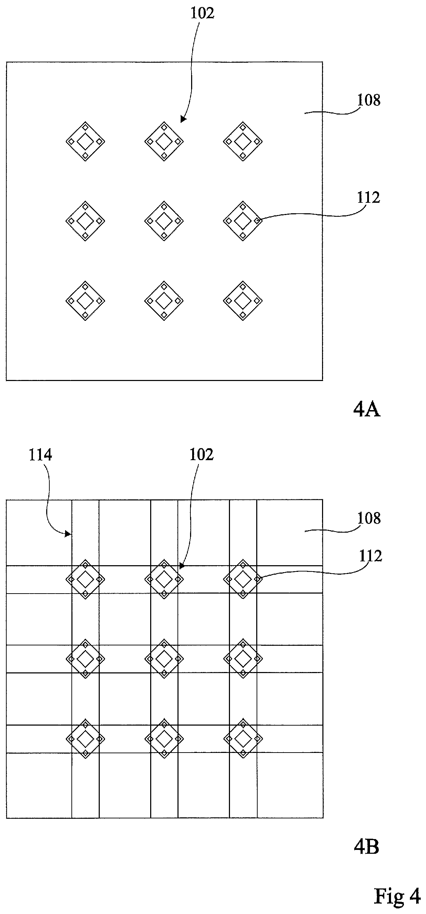

Les figures 2 à 4 illustrent, de façon partielle et schématique, des étapes d'un mode de réalisation d'un procédé de fabrication du dispositif électronique 100 de la figure 1. Plus précisément, la figure 2 illustre des vues 2A, 2B et 2C du procédé, la figure 3 illustre des vues 3A, 3B, 3C et 3D du procédé, et la figure 4 illustre des vues 4A et 4B du procédé.

La vue 2A est une vue en coupe de la structure obtenue après une étape au cours de laquelle des diodes électroluminescentes destinées à faire partie du circuit optoélectronique 104 sont formées sur un substrat 200. Cette étape est effectuée pleine plaque, c'est-à-dire que les diodes de plusieurs circuits optoélectroniques 104 sont formées simultanément sur le substrat 200.

Dans le présent mode de réalisation, les diodes électroluminescentes ont une structure planaire. À titre de variante, les diodes électroluminescentes peuvent avoir une structure tridimensionnelle telle que décrite dans le brevet US 9331242.

Le substrat 200 est recouvert d'un empilement de couches comprenant une couche semiconductrice 202, une couche active 204 et une couche semiconductrice 206. Les couches 202, 204, et 206 permettent de former les diodes électroluminescentes. La couche active d'une diode électroluminescente est la couche d'où est émis la majorité du rayonnement électromagnétique fourni par la diode électroluminescente. Des cavités 208, traversant entièrement les couches 206 et 204 et partiellement la couche 202, délimitent les diodes électroluminescentes dans l'empilement. La vue 2A représente trois ensembles 210 de trois diodes électroluminescentes. Chaque ensemble 210 correspond à un circuit optoélectronique 104. Chaque diode électroluminescente de chaque ensemble 210 est recouverte d'un plot conducteur 110 au contact de la couche semiconductrice 206. Chaque ensemble 210 comprend aussi un via conducteur 214, isolé électriquement des couches 204 et 206, prenant contact sur la couche 202, et connecté à un plot conducteur 216. Dans chaque ensemble 210, les diodes électroluminescentes de l'ensemble 210 sont ainsi commandées par la tension pouvant être fournie entre les plots 110 et 216.

La vue 2B est une vue en coupe de la structure obtenue après une étape postérieure de fabrication, effectuée pleine plaque, au cours de laquelle des composants électroniques, non représentés, de plusieurs circuits électroniques 106 sont formés dans un substrat 218. Les plots conducteurs 112, des plots conducteurs 217 et des plots conducteurs 111 sont formés sur le substrat 218. A titre de variante, le substrat 218 peut comprendre une face sensiblement plane au niveau de laquelle affleurent les plots conducteurs 111.

Les substrats 200 et 218 sont placés de manière à fixer, par exemple par collage moléculaire, les plots 111 avec les plots 110 et les plots 216 avec les plots 217. Ceci permet d'obtenir la connexion électrique entre les composants électroniques du substrat 218 et les diodes électroluminescentes.

La vue 2C est une vue en coupe de la structure obtenue après une étape postérieure de fabrication au cours de laquelle le substrat 200 est gravé pour former des murs 222 délimitant des zones 224 situées en regard de chaque diode électroluminescente. Ces zones 224 sont ensuite remplies de matériaux photoluminescents, formant ainsi des blocs photoluminescents, permettant par exemple de convertir le rayonnement émis par les diodes électroluminescentes en rayonnements à des longueurs d'onde différentes.

Les couches 202, 204 et 206 sont gravées de manière à séparer les différents ensembles 210, formant ainsi les circuits optoélectroniques 104.

La vue 3A est une vue en coupe agrandie au niveau d'une puce unique de la structure obtenue après une étape de fabrication au cours de laquelle une poignée 226 est fixée aux circuits optoélectroniques 104, plus précisément sur les blocs photoluminescents 224 et sur les murs 222, par exemple au moyen d'une colle. Une couche isolante non représentée peut recouvrir les faces latérales des circuits optoélectroniques 104.

La vue 3B est une vue en coupe de la structure obtenue après une étape de fabrication au cours de laquelle le substrat 218 peut être aminci du côté opposé aux plots 112 et est fixé sur le support 108. La poignée 226 est ensuite retirée.

Le support 108 est en un matériau étirable, tel que cela a été défini précédemment. Le support 108 est par exemple dans un état non étiré, c'est-à-dire qu'aucune force de traction n'est exercée sur le support 108.

La vue 3C est une vue en coupe de la structure obtenue après une étape postérieure de fabrication. Au cours de cette étape, le substrat 218 est gravé de manière à séparer les circuits électroniques 106 des différents pixels d'affichage 102.

La vue 3D est une vue de dessus du support 108 au cours de l'étape illustrée par la vue 3C.

Dans l'exemple de la vue 3D, le support 108 et l'ensemble des pixels d'affichage 102 ont des formes sensiblement rectangulaires et l'ensemble de pixels d'affichage 102 est placé de telle manière que chacun de ses côtés forme un angle sensiblement égal à 45° avec chaque côté du support 108. Plus généralement, le support 108 peut avoir une forme non rectangulaire et peut alors être, par exemple, étirée dans des directions à environ 45° des bords des pixels.

La vue 4A est une vue de dessus illustrant le résultat d'une étape postérieure de fabrication du dispositif électronique. Au cours de cette étape, le support 108 est étiré de manière à placer les puces 102 aux emplacements désirés. Selon le présent mode de réalisation, les puces 102 sont agencées, après l'étape d'étirement, sensiblement en lignes et en colonnes.

Selon un mode de réalisation, les puces 102 peuvent être, après l'étape illustrée par la vue 4A, transférées sur un autre support étirable, qui est ensuite étiré, de manière à augmenter la distance entre les puces. Cette étape peut être répétée plusieurs fois de manière à obtenir la distance souhaitée entre les puces.

La vue 4B est une vue de dessus illustrant le résultat d'une étape postérieure de fabrication. Au cours de cette étape, les bandes conductrices 114 sont formées sur le support 108 et sur les puces 102 en contact avec les plots conducteurs 112. Dans l'exemple de la figure 4B, chaque plot 112 de chaque puce 102 est connecté à une bande conductrice 114 commune avec d'autres puces 102 d'une même ligne ou d'une même colonne. Les bandes conductrices 114 sont par exemple formées par impression 3D. Un élément isolant, non représenté, est de préférence interposé entre les bandes conductrices 114, aux intersections des bandes conductrices 114, de manière à éviter les courts-circuits.

L'état étiré support 108 peut être maintenu par des éléments non représentés.

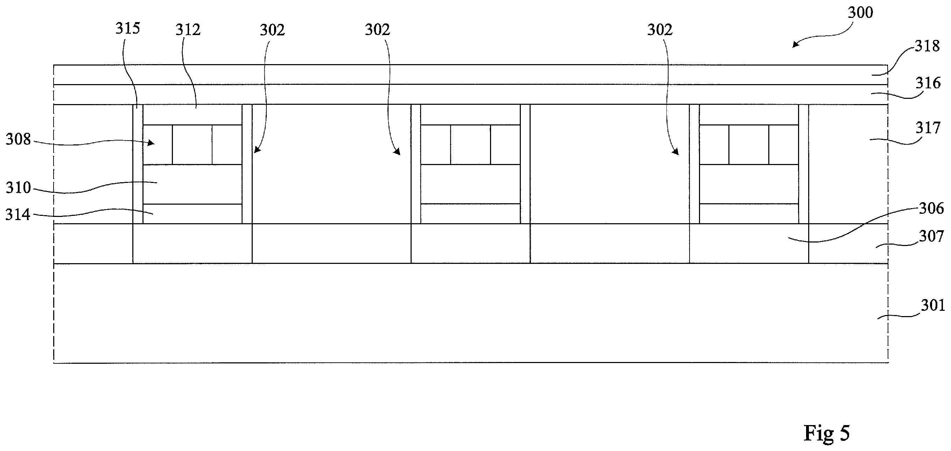

Selon un autre mode de réalisation, le support 108 peut être utilisé en tant que poignée à une étape intermédiaire d'un procédé de fabrication d'un dispositif électronique. Ainsi, les puces peuvent être reportées sur un autre support, par exemple non étirable. Un tel mode de réalisation de dispositif électronique est décrit en figure 5.

La figure 5 est une vue en coupe, partielle et schématique, représentant un autre mode de réalisation d'un dispositif électronique 300.

Le dispositif électronique 300 comprend un support 301 sur lequel reposent des puces 302, ici des pixels d'affichage. Le support 301 n'est de préférence pas étirable. Le support 301 peut être rigide ou flexible. De préférence, le support est noir, de manière à augmenter le contraste de l'écran. Il s'agit par exemple d'un support en un matériau semiconducteur, en verre ou en plastique. Des bandes conductrices 306 sont formées sur le support 301. Chaque bande conductrice peut être connectée aux pixels d'affichage d'une même ligne. Trois bandes conductrices sont représentés en figure 5. Une couche isolante 307 sépare les bandes conductrices 306.

Les pixels d'affichage 302 comprennent ici chacun un circuit optoélectronique 308 et un circuit électronique 310. Les circuits 308 et 310 sont par exemple similaires respectivement au circuit optoélectronique 104 et au circuit électronique 106 décrits précédemment en relation avec la figure 1. Chaque pixel d'affichage 302 comprend de plus une couche conductrice 312 recouvrant la face du circuit optoélectronique 308 opposée au circuit électronique 310 et une couche conductrice 314 recouvrant la face du circuit électronique 310 opposée au circuit optoélectronique 308. La couche 314 est en contact avec l'une des bandes conductrices 306. De préférence, la couche conductrice 312 est transparente aux rayonnements émis par le circuit optoélectronique 308. Les contacts du pixel 302 avec des éléments extérieurs sont faits par les couches 312 et 314. Le pixel 302 n'a donc pas de plot conducteur 112 (figure 1).

Les couches conductrices 312 et 314 constituent les seules bornes externes de chaque pixel d'affichage 302, c'est-à-dire les seules connexions entre le pixel d'affichage et des éléments externe au pixel d'affichage.

Chaque pixel 302 comprend par exemple uniquement deux connexions électriques, ici les couches conductrices 312 et 314. Chacune des deux connexions électriques permet d'interconnecter les pixels d'une même ligne ou d'une même colonne.

Chaque pixel d'affichage 302 est entouré d'un mur isolant 315. Plus précisément, les parois latérales des couches conductrices 312 et 314, du circuit optoélectronique 308 et du circuit électronique 310 de chaque pixel d'affichage 302 sont recouvertes du mur isolant 315. Une couche isolante 317 entoure les pixels d'affichage 302, la face supérieure de la couche 317 étant par exemple sensiblement coplanaire avec la face supérieure des couches conductrices 312.

Des bandes conductrices 316, une unique bande 316 étant représentée, recouvrent les pixels d'affichage 302 et la couche isolante 317. Chaque bande conductrice 316 recouvre les pixels d'une même colonne de la matrice de pixels et la couche isolante 317. La bande conductrice 316 est en contact avec les couches conductrices 312 des pixels de la colonne et constitue une électrode. Les pixels d'affichage d'une même colonne sont donc commandés par la tension fournie entre la bande 316 et les bandes conductrices 306.

A titre de variante, la bande conductrice 316 peut recouvrir des puces 302 de plus d'une colonne, par exemple les puces d'au moins deux colonnes. A titre de variante, une seule bande conductrice 316 peut recouvrir l'ensemble des puces 302 du dispositif 300.

Les bandes conductrices 316 sont de préférence transparentes aux rayonnements fournis par les pixels d'affichage 302. Les bandes conductrices 316 sont de préférence recouvertes d'une couche protectrice 318, par exemple en verre. La couche protectrice 318 est sensiblement transparente aux rayonnements fournis par les pixels d'affichage 302.

A titre de variante, le support 301 peut être en un polymère flexible et la couche protectrice 318 peut être en un plastique flexible.

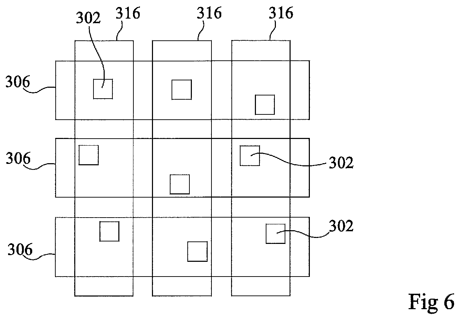

La figure 6 représente une vue de dessus schématique et partielle du mode de réalisation du dispositif 300 de la figure 5. Les bandes conductrices 306 sont sensiblement parallèles. Les bandes conductrices 316 sont également sensiblement parallèles et s'étendent perpendiculairement aux bandes conductrices 306. Chaque pixel d'affichage 302 est représenté par un carré. Les pixels d'affichage 302 sont situés aux intersections des bandes conductrices 306 et 316.

Les bandes conductrices 306 et 316, ont avantageusement des dimensions plus importantes que celles des pixels d'affichage 302 pour connecter les pixels d'affichage 302 de la ligne ou de la colonne correspondante même dans le cas où, comme en figure 6, les pixels 302 ne sont pas parfaitement alignés.

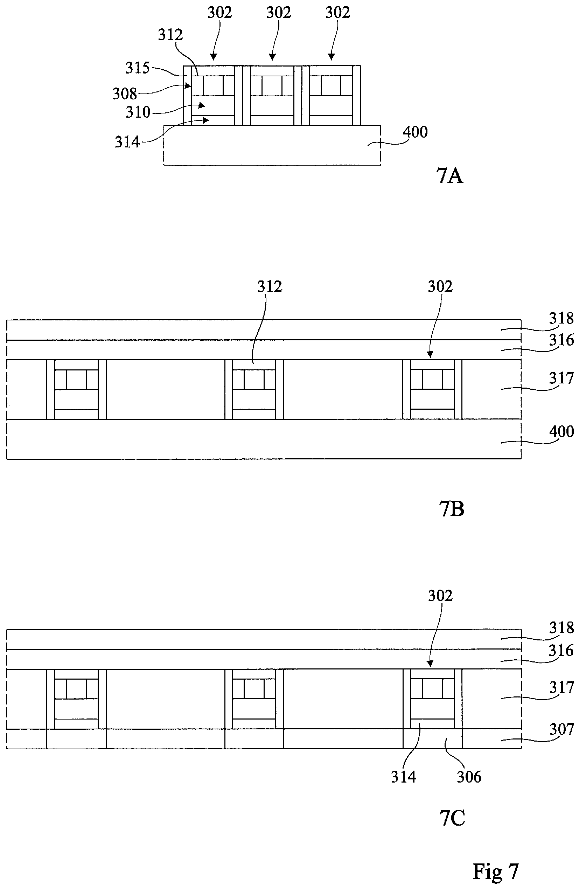

La figure 7 comprend des vues en coupe partielles et schématiques, illustrant des étapes d'un mode de réalisation d'un procédé de fabrication du dispositif électronique 300 de la figure 5.

La vue 7A illustre le résultat d'étapes de fabrication au cours desquelles une plaque de puces 302, comprenant chacune les couches conductrices 312 et 314, le circuit optoélectronique 308 et le circuit électronique 310, est formée et est ensuite reportée sur un support étirable 400, par exemple à l'aide d'une poignée non représentée qui est ensuite retirée. Les puces 302 sont ensuite individualisées et les murs isolants 315 sont formés sur les parois latérales des puces 302.

La vue 7B illustre le résultat d'une étape postérieure de fabrication au cours de laquelle le support 400 a été étiré de manière à placer les puces 302 aux endroits désirés. La couche isolante 317 est déposée autour des puces 302. La couche isolante 316 est formée sur les puces 302 et sur la couche 317. La couche 316 est formée de manière à être en contact avec les couches conductrices 312. La couche protectrice 318, par exemple en verre, est fixée à la couche 316, par exemple au moyen d'une colle.

La vue 7C illustre le résultat d'une étape postérieure de fabrication au cours de laquelle le support 400 est retiré. Les bandes conductrices 306 sont formées en contact avec les couches conductrices 314. Les bandes conductrices 306 sont entourées de la couche isolante 307.

Des étapes non représentées sont ensuite effectuées pour obtenir le mode de réalisation de la figure 5. Au cours de ces étapes, les pixels d'affichage 302 sont déposés sur le support 301.

À titre de variante, la couche isolante 307 peut ne recouvrir que les parois latérales des bandes conductrices 306, et ne pas recouvrir entièrement le support 300. La couche isolante 307 n'est donc pas continue. Dans cette variante, le support 301 est par exemple en un matériau noir et isolant au moins en surface. Ainsi les portions du support 301 noir pouvant être observé à travers les discontinuités de la couche 307 permettent un meilleur contraste dans le cas où le dispositif est un écran d'affichage.

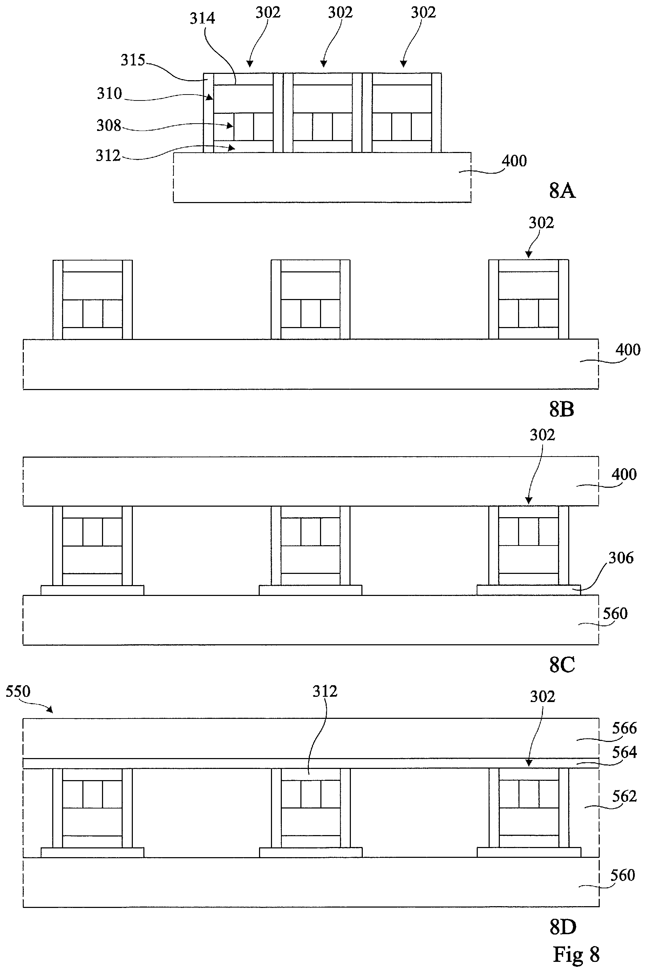

La figure 8 comprend des vues en coupe, partielles et schématiques, illustrant des étapes d'un mode de réalisation d'un procédé de fabrication d'un dispositif 550, similaire au dispositif représenté en figure 5.

La vue 8A illustre le résultat d'étapes de fabrication, similaires aux étapes décrites en relation avec la vue 6A de la figure 6, au cours desquelles une plaque de puces 302, comprenant chacune les couches conductrices 312 et 314, le circuit optoélectronique 308 et le circuit électronique 310, est formée et est ensuite reportée sur un support étirable 400, par exemple en utilisant une poignée non représentée. Selon l'exemple décrit en relation avec la figure 8, le support 400 est situé du côté du circuit optoélectronique 308, c'est-à-dire en contact avec la couche conductrice 312 de chaque puce 302. Les puces 302 sont ensuite individualisées et les murs isolants 315 sont formés sur les parois latérales des puces 302.

La vue 8B illustre le résultat d'une étape postérieure de fabrication au cours de laquelle le support 400 a été étiré de manière à placer les puces 302 aux endroits désirés.

La vue 8C illustre le résultat d'une étape au cours de laquelle les pixels d'affichage 302 sont reportés sur des bandes conductrices 306 situées sur un support 560. Le support 560 est de préférence un support rigide non élastique ou un support souple. Le support 560 est par exemple en un matériau de couleur noire.

La vue 8D illustre le résultat d'une étape au cours de laquelle le support étirable 400 est retiré. Les pixels d'affichage 302 sont ensuite entourés d'une couche isolante 562 recouvrant le support 560 autour des pixels d'affichage 302. La face supérieure de la couche isolante 562 est par exemple coplanaire avec la face supérieure de la couche conductrice 312.

Des couches conductrices 564 sont formées sur les pixels d'affichage 302 et sur la couche isolante 562 de manière à connecter ensemble les couches conductrices 312 des pixels de mêmes colonnes. Les couches 564 sont de préférence sensiblement transparentes aux rayonnements émis par les pixels d'affichage 302.

Une couche protectrice 566, par exemple en verre, est ensuite formée sur les couches conductrices 564 et sur les parties de la couche isolante 562 non recouvertes par les couches conductrices 564. La couche protectrice 566 est de préférence sensiblement transparente aux rayonnements émis par les pixels d'affichage 302.

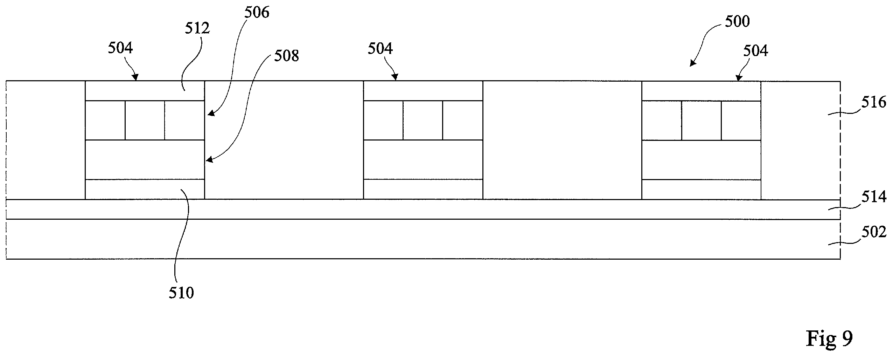

La figure 9 illustre un autre mode de réalisation d'un dispositif électronique 500. Le dispositif électronique 500 comprend, comme le dispositif électronique 100 de la figure 1, un support 502 étirable, comme cela été défini précédemment. Le dispositif électronique 500 comprend de plus une pluralité de puces 504, dont trois sont représentées ici, similaires aux puces 302 de la figure 3. Ainsi, les puces 504 sont des pixels d'affichage comprenant chacune un circuit optoélectronique 506, similaire au circuit optoélectronique 308, un circuit électronique 508, similaire au circuit électronique 310, et des couches conductrices 510 et 512 similaires respectivement aux couches conductrices 314 et 312.

Des éléments conducteurs 514 sont situés sur le support 502. Les éléments conducteurs 514 comprennent par exemple des plots conducteurs en contact avec les couches conductrices 510, et des bandes conductrices connectant ensemble des plots. Chaque élément conducteur connecte par exemple les pixels d'affichage d'une ligne de pixels. Une couche isolante 516 est située autour des puces 504.

Les éléments conducteurs 514 sont au moins partiellement étirables ou déformables. Par exemple, les plots conducteurs ne sont pas étirables et les bandes conductrices sont étirables.

Des éléments conducteurs non représentés, par exemple des bandes conductrices, peuvent être formés sur la couche 516 de manière à connecter ensemble certaines des couches conductrices 512, par exemple les couches conductrices 512 des pixels d'affichage d'une colonne de pixels d'affichage.

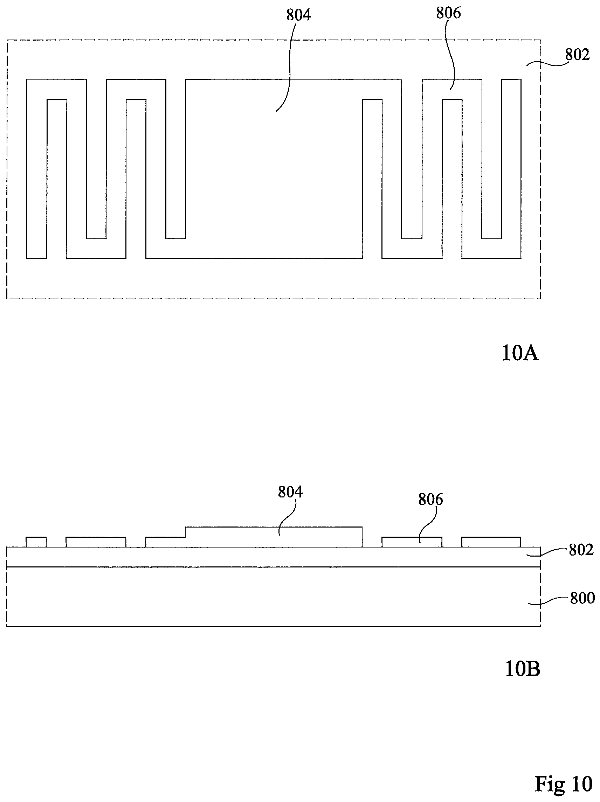

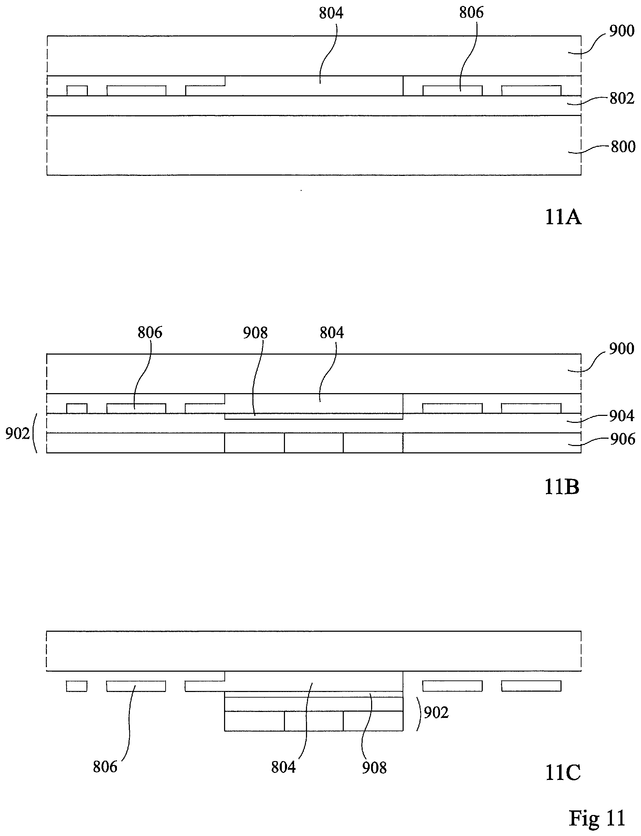

Les figures 10 et 11 illustrent, de façon partielle et schématique, des étapes d'un mode de réalisation d'un procédé de fabrication des éléments conducteurs 514 étirables. Plus précisément, la figure 10 illustre des vues 10A et 10B et la figure 11 illustre des vues 11A, 11B et 11C.

Les vues 10A et 10B sont respectivement une vue de dessus et une vue en coupe illustrant le résultat d'une étape de fabrication. Au cours de cette étape, une couche conductrice est déposée sur un substrat 800. Dans l'exemple décrit, la couche conductrice est séparée du substrat 800 par une couche isolante 802. La couche conductrice est gravée de manière à former des plots conducteurs 804 et des bandes conductrices 806. Un seul plot conducteur 804 et deux bandes conductrices 806 sont représentés sur les figures 10 et 11.

Dans l'exemple des figures 10A et 10B, l'épaisseur des plots conducteurs 804 est supérieure à l'épaisseur des bandes conductrices 806. À titre d'exemple, l'épaisseur des bandes conductrices 806 varie de 1,01 à 10 fois l'épaisseur des plots conducteurs 804 et l'épaisseur des plots conducteurs 804 est comprise entre 20 nm et 1 mm.

A titre de variante, les plots conducteurs 804 et les bandes conductrices 806 peuvent avoir la même épaisseur. Par exemple, le support étirable peut alors comprendre des cavités aux emplacements des bandes conductrices, de telle manière que les bandes conductrices 806 ne soient pas en contact avec le support étirable.

Les plots conducteurs 804 sont destinés à être connectés à des puces. Les bandes conductrices 806 sont en contact avec au moins un plot conducteur 804 et sont adaptées à connecter électriquement les plots 804 entre eux ou à d'autres éléments conducteurs non représentés. Selon un mode de réalisation, chaque bande conductrice 806 a une forme en zig-zag et est relié à au moins une extrémité à un plot conducteur 804.

La gravure de la couche conductrice est par exemple effectuée en formant un masque, non représenté, formé en plusieurs étapes sur la couche conductrice. Le masque comprend des zones ayant une première épaisseur aux emplacements où seront formés les plots conducteurs 804, des zones ayant une deuxième épaisseur aux emplacements où seront formées les bandes conductrices 806 et une troisième épaisseur ailleurs. La troisième épaisseur correspond par exemple à une gravure entière du masque.

Le masque est par exemple en oxyde de silicium. Les plots conducteurs 804 et les bandes conductrices 806 sont par exemple en métal, par exemple en aluminium. Le substrat 800 est par exemple en silicium et a par exemple une épaisseur d'environ 750 µm. La couche isolante 802 est par exemple en polymère, notamment en polyemide formé par un dépôt à la tournette.

La vue 11A est une vue en coupe illustrant le résultat d'une étape postérieure de fabrication. Au cours de cette étape, un support étirable 900, similaire au support 400 ou au support 108, est fixé aux plots conducteurs 804, par exemple au moyen d'une colle, par exemple d'un matériau adhésif de masquage bleu, généralement connu sous l'appellation "Blue Tape".

L'épaisseur des bandes conductrices 806 est inférieure à l'épaisseur du plot conducteur 804 de sorte que les bandes 806 ne sont pas en contact avec le support étirable 900.

La vue 11B illustre le résultat d'une étape postérieure de fabrication. Au cours de cette étape, le substrat 800, ainsi que la couche 802, sont retirés complétement, de manière à découvrir les plots conducteurs 804 et les bandes conductrices 806. Une plaque 902, comprenant par exemple une plaque 904 de circuits électroniques similaires aux circuits électroniques 310 ou 508, et une plaque 906 de circuits optoélectroniques similaires aux circuits optoélectroniques 308, 506, est déposée en contact avec les plots conducteurs 804 et les bandes conductrices 806. La plaque 902 comprend aussi par exemple des plots conducteurs 908 situés entre la plaque 904 et les plots 804.

La vue 11C illustre le résultat d'une étape de fabrication au cours de laquelle la plaque 902 est gravée de manière à ne conserver que les puces. Plus précisément les portions de la plaque 902 située en regard des bandes conductrices 806 sont gravées. Ainsi, lorsque le support 800 est retiré, les bandes conductrices 806 ne sont maintenues que par leur contact avec les plots 804 et peuvent donc être déformé.

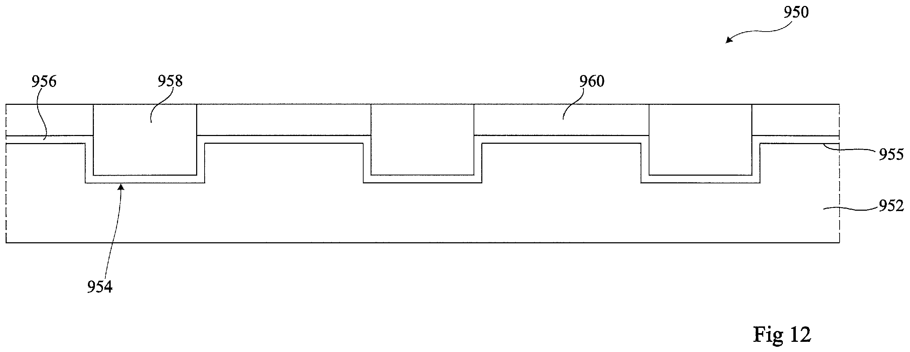

La figure 12 est une vue en coupe illustrant un autre mode de réalisation d'un dispositif électronique 950.

Le dispositif 950 comprend un support étirable 952 dans un état étiré. Le support étirable 952 comprend des cavités 954 formées depuis la face 955 du support 952. Des éléments conducteurs 956 peuvent être situés sur une partie de la face 955 et dans les cavités 954.

Des puces 958, par exemple des pixels d'affichage, sont situées au moins partiellement dans les cavités 954. Plus précisément, une partie de chaque puce 958 est par exemple située dans une cavité 954 et est en contact avec une partie d'un élément conducteur 956 et une autre partie de chaque puce est par exemple située en dehors de la cavité 954. Les éléments conducteurs 956 permettent ainsi de connecter électriquement plusieurs puces 958. Dans l'exemple de la figure 10, les trois puces représentées sont connectées par le même élément conducteur 956.

Les éléments conducteurs 956 sont par exemple au moins partiellement étirables et/ou déformables. Par exemple, les parties des éléments conducteurs 956 situées dans les cavités 954 ne sont pas étirables ou déformables, et les parties des éléments conducteurs 956 situées sur la face 955 du support 952 sont étirables et/ou déformables. Les parties des éléments conducteurs 956 situés sur la face 955 sont par exemple similaires aux bandes conductrices 806 décrites précédemment en relation avec les figures 8 et 9 et ne sont alors pas fixée à la face 955 du support 952.

Les parties des puces 958 situées en dehors des cavités 954 sont entourées d'une couche isolante 960. La couche isolante 960 est par exemple formée de manière à laisser découverte une face de chaque puce 958.

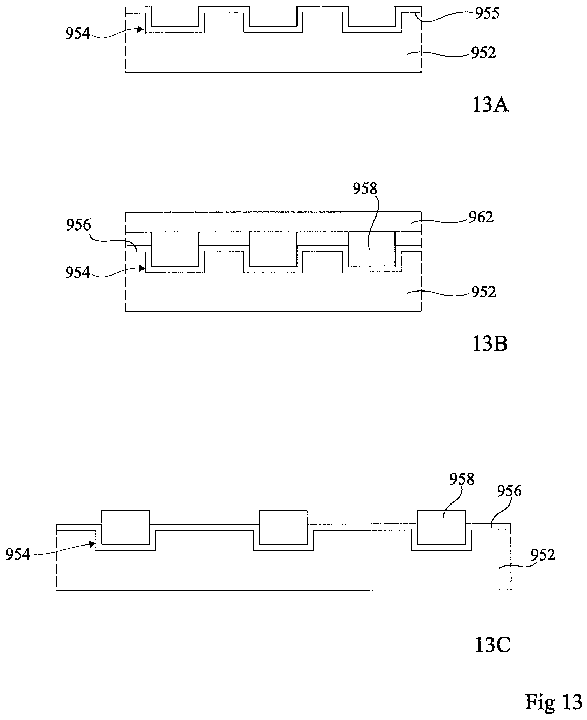

La figure 13 illustre, de façon partielle et schématique, des étapes d'un mode de réalisation d'un procédé de fabrication du dispositif électronique 950 de la figure 12. Plus précisément, la figure 11 illustre des vues 13A, 13B et 13C du procédé de fabrication.

La vue 13A illustre une étape de fabrication au cours de laquelle les cavités 954 sont gravées dans le support 952. Le support 952 est alors de préférence dans un état non étiré.

Les éléments conducteurs 956 sont ensuite formés. Par exemple, une couche conductrice peut être formée sur la face 955 et sur les parois et le fond des cavités 954, puis être gravée de manière à former les éléments conducteurs 956. Les éléments conducteurs 956 sont par exemple formés en deux étapes : une étape au cours de laquelle le fond et les parois des cavités sont recouverts d'une couche conductrice et une étape au cours de laquelle des éléments conducteurs étirables déformables sont formés sur la face 955, par exemple en mettant en œuvre un procédé par décollement (lift-off) utilisant une couche sacrificielle interposée entre les éléments conducteurs 956 et la face 955.

La vue 13B illustre une étape postérieure de fabrication au cours de laquelle les puces 958 sont placées dans les cavités 954, en contact avec les éléments conducteurs 956.

Les puces 958 sont par exemple formées dans une même plaque. Une poignée 962 est ensuite collée à la plaque. Les différentes puces 958 sont ensuite individualisées. La distance entre les différentes puces 958 est la même que la distance entre les différentes cavités 954 lorsque le support 952 n'est pas étiré. Ainsi, il est possible de placer simultanément l'ensemble des puces 958 dans les cavités 954.

Dans le cas où chaque puce comprend un circuit électronique et un circuit optoélectronique, le circuit électronique est du côté des éléments conducteurs 956 et le circuit optoélectronique est du côté de la poignée 962.

La vue 13C illustre une étape postérieure de fabrication au cours de laquelle la poignée 962 est retirée et le support 952 est étiré. Les parties étirables et/ou déformables des éléments conducteurs 956 sont alors étirées et/ou déformées en même temps que le support 952.

Le procédé de fabrication peut comprendre des étapes postérieures non représentées, par exemple, la formation de la couche 960 autour des puces 958.

Un avantage des modes de réalisation de procédés de fabrication décrits précédemment est qu'ils permettent d'obtenir des dispositifs électroniques comprenant une pluralité de puces plus rapidement et à un coût réduit par rapport aux procédés usuels.

Divers modes de réalisation et variantes ont été décrits. Ces divers modes de réalisation et variantes sont combinables et d'autres variantes apparaitront à l'homme de l'art. En particulier, on a décrit ici des modes de réalisation dans lesquels les puces sont des pixels d'affichage. Cependant, les puces peuvent correspondre à n'importe quel type de puces électroniques que l'on cherche à placer sur un même support, par exemple des capteurs tels que des photodétecteurs. Enfin, la mise en oeuvre pratique des modes de réalisation et variantes décrits est à la portée de l'homme du métier à partir des indications fonctionnelles données ci-dessus.

## Revendications

1. Procédé de fabrication d'un dispositif électronique (100, 300, 500, 950) comprenant les étapes suivantes :
a) former une plaque (218, 962) qui comporte une pluralité de puces électroniques (102, 302, 504, 958) ;
b) fixer la plaque de puces électroniques à un premier support (108, 400, 502, 900, 952) en un matériau étirable ;
c) retirer et/ou graver la plaque ;
d) étirer le premier support de manière à écarter les puces les unes des autres ;
f) reporter, après l'étape d), sur un deuxième support (301) des puces (302) depuis le premier support (108, 400) ; et
g) après l'étape f), retirer le premier support (108, 400).

2. Procédé selon la revendication 1, comprenant, avant l'étape b), une étape de formation de premiers éléments conducteurs (514, 956) sur le premier support (502, 900, 952).

3. Procédé selon la revendication 2, dans lequel les premiers éléments conducteurs (514, 956) sont étirables et/ou déformables.

4. Procédé selon la revendication 2 ou 3, dans lequel la formation des premiers éléments conducteurs (804, 806) comprend les étapes suivantes :
former une couche conductrice sur un substrat (800) ;
graver la couche conductrice de manière à former les premiers éléments conducteurs (804, 806), les premiers éléments conducteurs comprenant des plots (804) et des bandes (806) en forme de zig-zag, chaque bande étant en contact avec au moins un plot ; et
reporter les plots et les bandes sur le premier support (900) de manière que les bandes ne soient pas en contact avec le premier support.

5. Procédé selon la revendication 4, dans lequel l'épaisseur des bandes est inférieure à l'épaisseur des plots.

6. Procédé selon l'une quelconque des revendications 1 à 5, comprenant la formation de deuxièmes éléments conducteurs (114, 316) sur le côté des puces (102, 302) opposé au premier support (108, 400) et/ou au-dessus des puces (102, 302).

7. Procédé selon la revendication 6, dans lequel la formation des deuxièmes éléments conducteurs (114, 316) est effectuée après l'étape d).

8. Procédé selon l'une quelconque des revendications 1 à 7, dans lequel chaque puce électronique comprend un circuit optoélectronique et un circuit électronique adapté à commander le circuit optoélectronique.

9. Procédé selon l'une quelconque des revendications 1 à 8, dans lequel chaque puce électronique comprend uniquement deux bornes externes de connexion électronique.

10. Procédé selon l'une quelconque des revendications 1 à 9, comprenant les étapes suivantes postérieures à l'étape d) :
e) former, avant l'étape f), du côté d'une face émettrice de lumière, des éléments conducteurs, sensiblement transparents au rayonnement émis par les puces de manière à interconnecter des lignes de puces ;
entre les étapes e) et g):
f) reporter les puces sur un troisième support sensiblement transparent au rayonnement émis par les puces;
h) former des couches conductrices (316) de manière à interconnecter des colonnes de puces,
le troisième support étant sensiblement transparent au rayonnement émis par les puces.

11. Procédé selon la revendication 10, comprenant, après l'étape h), une étape de report sur un quatrième support (301) des puces (302) depuis le deuxième support (400).

12. Procédé selon l'une quelconque des revendications 1 à 11, dans lequel le premier support comprend des premiers éléments conducteurs formant des lignes, chaque puce étant connectée, à l'étape b), à l'un des éléments conducteurs.

13. Procédé selon la revendication 12, dans lequel des deuxièmes éléments conducteurs formant des colonnes sont formés sur la face des puces opposée au premier support (108).

## Patentansprüche

1. Ein Verfahren zum Herstellen einer elektronischen Vorrichtung (100, 300, 500, 950), das die folgenden Schritte aufweist:
a) Ausbilden eines Wafers (218, 962), der eine Vielzahl von elektronischen Chips (102, 302, 504, 958) aufweist;
b) Befestigen des Wafers aus elektronischen Chips an einem ersten Träger (108, 400, 502, 900, 952), der aus einem dehnbaren Material besteht;
c) Entfernen und/oder Ätzen des Wafers;
d) Dehnen des ersten Trägers, um die Chips voneinander weg zu bewegen;
e) Übertragen, nach Schritt d), der Chips (302) auf einen zweiten Träger (301) vom ersten Träger (108, 400); und
g) nach Schritt f), Entfernen des ersten Trägers (108, 400).

2. Das Verfahren nach Anspruch 1, aufweisend, vor Schritt b), einen Schritt des Ausbildens erster leitfähiger Elemente (514, 956) auf dem ersten Träger (502, 900, 952).

3. Das Verfahren nach Anspruch 2, wobei die ersten leitfähigen Elemente (514, 956) dehnbar und/oder verformbar sind.

4. Das Verfahren nach Anspruch 2 oder 3, wobei das Ausbilden der ersten leitfähigen Elemente (804, 806) die folgenden Schritte aufweist:
Ausbilden einer leitfähigen Schicht auf einem Substrat (800);
Ätzen der leitfähigen Schicht, um erste leitfähige Elemente (804, 806) auszubilden, wobei die ersten leitfähigen Elemente Pads (804) und Streifen (806) in einem Zickzackmuster aufweisen, wobei jeder Streifen mit wenigstens einem Pad in Kontakt steht; und
Übertragen der Pads und der Streifen auf den ersten Träger (900), so dass die Streifen nicht mit dem ersten Träger in Kontakt stehen.

5. Das Verfahren nach Anspruch 4, wobei die Dicke der Streifen geringer ist als die Dicke der Pads.

6. Das Verfahren nach einem der Ansprüche 1 bis 5, aufweisend das Ausbilden von zweiten leitfähigen Elementen (114, 316) auf der Seite der Chips (102, 302), die dem ersten Träger (108, 400) gegenüberliegt, und/oder über den Chips (102, 302).

7. Das Verfahren nach Anspruch 6, wobei das Ausbilden der zweiten leitfähigen Elemente (114, 316) nach Schritt d) durchgeführt wird.

8. Das Verfahren nach einem der Ansprüche 1 bis 7, wobei jeder elektronische Chip eine optoelektronische Schaltung und eine elektronische Schaltung aufweist, die eingerichtet ist zum Steuern der optoelektronischen Schaltung.

9. Das Verfahren nach einem der Ansprüche 1 bis 8, wobei jeder elektronische Chip nur zwei externe elektronische Anschlussterminals aufweist.

10. Das Verfahren nach einem der Ansprüche 1 bis 9, ferner aufweisend nach Schritt d) die folgenden Schritte:
e) Ausbilden, vor Schritt f), auf der Seite der lichtemittierenden Oberfläche, von leitfähigen Elementen, die im Wesentlichen transparent für die Strahlung sind, die von den Chips emittiert wird, um Zeilen von Chips miteinander zu verbinden; zwischen den Schritten e) und g):
f) Übertragen der Chips auf einen dritten Träger, der im Wesentlichen transparent für die Strahlung ist, die von den Chips emittiert wird;
h) Ausbilden von leitfähigen Schichten (316), um Chip-Spalten miteinander zu verbinden, wobei
der dritte Träger im Wesentlichen transparent für die Strahlung ist, die von den Chips emittiert wird.

11. Das Verfahren nach Anspruch 10, aufweisend, nach Schritt h), einen Schritt des Übertragens auf einen vierten Träger (301) der Chips (302) von dem zweiten Träger (400).

12. Das Verfahren nach einem der Ansprüche 1 bis 11, wobei der erste Träger erste leitfähige Elemente aufweist, die Zeilen bilden, wobei jeder Chip in Schritt b) mit einem der leitfähigen Elemente verbunden wird.

13. Das Verfahren nach Anspruch 12, wobei zweite leitfähige Elemente, die Spalten bilden, auf der Oberfläche der Chips ausgebildet werden, die dem ersten Träger (108) gegenüberliegt.

## Claims

1. A method for manufacturing an electronic device (100, 300, 500, 950) comprising the following steps:
a) forming a wafer (218, 962) comprising a plurality of electronic chips (102, 302, 504, 958);
b) fixing the wafer of electronic chips to a first support (108, 400, 502, 900, 952) made of a stretchable material;
c) removing and/or etching the wafer;
d) stretching the first support so as to move the chips away from one another;
e) transferring, after step d), the chips (302) onto a second support (301) from the first support (108, 400); and
g) after step f), removing the first support (108, 400).

2. The method according to claim 1, comprising, before step b), a step of forming first conductive elements (514, 956) on the first support (502, 900, 952).

3. The method according to claim 2, wherein the first conductive elements (514, 956) are stretchable and/or deformable.

4. The method according to claim 2 or 3, wherein the formation of the first conductive elements (804, 806) comprises the following steps:
forming a conductive layer on a substrate (800);
etching the conductive layer so as to form first conductive elements (804, 806), the first conductive elements comprising pads (804) and strips (806) in a zigzag pattern, each strip being in contact with at least one pad; and
transferring the pads and the strips onto the first support (900) so that the strips are not in contact with the first support.

5. The method according to claim 4, wherein the thickness of the strips is less than the thickness of the pads.

6. The method according to any one of claims 1 to 5, comprising the formation of second conductive elements (114, 316) on the side of the chips (102, 302) opposite the first support (108, 400) and/or above the chips (102, 302).

7. The method according to claim 6, wherein the formation of the second conductive elements (114, 316) is carried out after step d).

8. The method according to any one of claims 1 to 7, wherein each electronic chip comprises an optoelectronic circuit and an electronic circuit adapted to control the optoelectronic circuit.

9. The method according to any one of claims 1 to 8, wherein each electronic chip only comprises two external electronic connection terminals.

10. The method according to any one of claims 1 to 9, comprising the following steps subsequent to step d):
e) forming, before step f), on the side of the light-emitting face, conductive elements, substantially transparent to the radiation emitted by the chips so as to interconnect lines of chips;
between steps e) and g):
f) transferring the chips onto a third support substantially transparent to the radiation emitted by the chips;
h) forming conductive layers (316) so as to interconnect columns of chips,
the third support being substantially transparent to the radiation emitted by the chips.

11. The method according to claim 10, comprising, after step h), a step of transferring on a fourth support (301) the chips (302) from the second support (400).

12. The method according to any one of claims 1 to 11, wherein the first support comprises first conductive elements forming lines, each chip being connected, in step b), to one of the conductive elements.

13. The method according to claim 12, wherein second conductive elements forming columns are formed on the face of the chips opposite the first support (108).
